# EUROPEAN PATENT APPLICATION

(11) **EP 0 807 826 A2**
(43) Date of publication of application: **19.11.1997**
(21) Application number: 97201391.6
(22) Date of filing: 14.05.1997
(51) Int. Cl.: G01R 31/36, H01M 10/48

(54) **Pilot cell for a battery**

(30) Priority: 14.05.1996 SE 9601837
(71) Applicant: INTRA DEVELOPMENT A/S, 2605 Brondby (DK)
(72) Inventor: Thomsen, Jes, 2300 Copenhagen (DK)
(74) Representative: Rosenquist, Per Olof

(57) **Abstract**

A pilot cell having electrode plates (27, 29) is intended to be inserted in a cell in a storage battery of lead acid type. The plates (27, 29) are located at a small distance of each other in a solid housing (3), the electrolyte of the battery cell penetrating therebetween contacting only the inner, facing surfaces of the plates. The voltage over the plates (27, 29) is measured and at the same time the voltage of the plates of a reference cell (35) that is enclosed in the same housing (3) as the pilot cell plates (27, 29) but totally separate from the electrolyte of the battery cell. Based on these measurements and the temperature the remaining charge capacity of the battery is calculated. The level of the electrolyte in the battery cell is checked by measuring the voltage over a secondary cell having one plate (45) that has a lower edge placed at a suitable level and one of the plates (27 or 29) of the pilot cell. A compact unit is provided which can be mounted in a refill or inspection hole in a battery cell and by means of which a reliable charge capacity estimate can be made.

## Description

### TECHNICAL FIELD

The present invention relates to a pilot cell or special sensor, i.e. generally a measurement device, for measuring the charge state and thereby the acid density of a storage battery, in particular for a battery of the lead acid type, for example a starter battery for a motor vehicle.

### BACKGROUND AND PRIOR ART

In many application fields there generally exists a need for an estimation of the remaining charge of an electrolytic battery used for powering some device, sometimes constantly, sometimes only at rather rarely occurring times. For example, motor vehicles having internal combustion engines are most often started by means of an electrically powered starter motor, which receives its powering current from a battery comprising several electrolytic battery cells connected in series. For an efficient use of the battery it has to be monitored, for example in the case where it is used in intelligent battery systems such as those proposed in the International patent applications Nos. PCT/SE95/00767 and PCT/IB95/ 00835. The remaining charge of the battery in such automotive systems has to be constantly estimated. Several methods therefor have been disclosed. For example, the voltage over the battery and the current flowing through the battery can be monitored and then the remaining charge calculated from measured values as described in documents cited in said International patent applications.

The charge condition at a specific time can also be derived from other measurements directly on the battery. Thus, U.S. patent US-A 1,373,951 discloses an indicating device for a storage-battery intended to be inserted in the electrolyte for producing an electrical current and to determine thereby the specific gravity of the electrolyte. The device acts in the nature of a miniature battery comprising non-corrosive metal plates on the exterior sides of a central hollow member and inside a perforated hollow lower cap, the electrolyte entering an annular space between the metal space and the interior side of the hollow cap.

The German patent DE-C1 32 20 147 discloses determination of the charge condition of a battery using a measurement device having two electrodes of the same material as the battery itself. The electrodes are applied to a central isolating strip and are in contact with the electrolyte at small oppositely facing surface areas. In U.S. patent 5,304,433 corresponding to the published European patent application EP-A1 0 595 466 a charge capacity indicator for a lead-acid battery is disclosed having a reference electrode of e.g. PbO₂, the voltage being measured between the reference electrode and the negative plates of the battery.

The charge condition of a battery can also be determined by measuring the capacitance of capacitors formed by plates inserted in the electrolyte, as disclosed in the German published patent application DE-B2 24 13 818. The electrolyte level of a battery can be determined by means of an electrode projecting downwards into the electrolyte and terminating at a predetermined level, forming thereby an electrolytic cell, the voltage of which is monitored, see e.g. U.S. patent 1,634,176.

### SUMMARY

It is an object of the invention to provide a measurement device for a cell of an electrochemical battery that provides signals from which the state of the battery can be deduced and in particular the remaining charge of the battery.

It is a further object of the invention to provide a compact measurement device made as basically one unit or package providing different signals informing on the state of the electrolyte in a cell of an electrochemical battery.

Thus, a measurement device, hereinafter also called a pilot cell, is provided having electrode plates and intended to be inserted in a cell of a conventional storage battery, such a battery of the lead-acid type. The pilot cell plates are located at a small distance of each other, so that the electrolyte of the battery cell can penetrate therebetween contacting only the inner, opposite surfaces of the plates. The voltage over the plates is measured and at the same time the voltage of the electrode plates of a reference cell that is enclosed in the same housing as the pilot cell plates but totally separate from the electrolyte of the battery cell. Based on the measurement and the temperature the remaining charge capacity of the battery is calculated. The level of the electrolyte in the battery cell is checked by measuring the voltage over a secondary cell having one electrode plate of its own that has its lower edge placed at a suitable level above the bottom level of other electrode plates, the second electrode plate of the secondary cell being one of the plates of the pilot cell. As an alternative the electrical resistance can be measured between the plates of said secondary cell. A compact one-piece unit is obtained in this way which can be mounted in a refill or inspection hole in a battery cell and by means of which a reliable charge capacity estimate can be made.

Thus generally, a measurement device is provided for insertion in the electrolyte of a storage battery that preferably is the lead-acid type. The device has a first electrode plate pair, the electrodes of which have active surfaces which are in contact with the electrolyte of the battery and that forms a pilot cell or measurement cell. The plates of the first pair are principally the same kind as the electrodes of the storage battery, in which the measurement device is used. The measurement device also comprises a reference cell that has a second pair of electrodes which also are the same kind as the electrodes of the storage battery but they are in contact with an amount of electrolyte of the same kind as that of the storage battery but totally physically and electrically separate therefrom, thus enclosed in a space which is not connected to the storage battery electrolyte.

A control circuit may be connected to the electrodes of the first and second pairs. It is then arranged to receive the voltages from the cells and in particular to measure the open circuit voltages thereof. Before each such measurement, it can charge both the measurement voltage cell and the reference voltage cell for a relatively short time period of predetermined length, this ensuring that these cells actually are charged at the time when the measurement is made. Before each such measurement, it can also introduce a delay of a predetermined length, the delay then following after charging the measurement voltage cell and the reference voltage cell. The delay makes the subsequent measurement more reliable, allowing the structure of the active surfaces of electrodes to relax and stabilize. Also it can be advantageous to reverse the polarity of the charge voltage which is used for charging the measurement voltage cell and the reference voltage cell, such a polarity change then being made between each measurement of the voltages of these cells or equivalently before each such measurement. Such an operation will also improve the state of the active surfaces of the electrodes, making the subsequent measurements having a higher quality. Moreover, the control circuit can check, before a measurement of the voltages of the measurement voltage cell and the reference voltage cell is made, whether the storage battery has been in a rest or inactive state for a predetermined time period. The existence of such an inactive state before the measurement steps will also improve the measurements to be made.

The measurement device can further include a sensor element for indicating whether the level of the battery electrolyte is higher or lower than a predetermined level. The sensor element comprises an electrode of the same kind as one of the electrodes of the storage battery. This level electrode is intended to inserted into the space where the battery electrolyte is. It has an active surface which then is in contact with the storage battery electrolyte and this active surface of the electrode has a lower edge located at the predetermined level. The electrode forms together with some other electrode of the device or battery a cell which will only have a definite voltage of the electrodes thereof in the case where there is an electrolyte connecting the electrodes. This cell is then preferably connected to a control device, checking the voltage over the formed cell periodically and outputting an alarm signal in the case where no voltage has been detected during a suitably long, selected time period comprising several checks of the cell of the voltage. Instead of a voltage measurement a simple level monitoring can be performed by measuring the resistance between the level electrode and the other plate, for instance by applying a suitable AC-voltage to the plates.

The measurement cell of the measurement device has also advantageously its electrode plates located so that only their active surfaces which are in contact with the electrolyte of the battery face each other at a small distance, the distance being significantly smaller than the width of active surfaces or of the electrodes. The active surfaces of the electrode plates may be arranged inside a channel extending through a body or house of the measurement device.

The measuring elements of the measurement device can all be accommodated in a single body or housing having a generally cylindrical shape, the body being basically solid having a channel or slot extending transversely through it, an opening also extending transversely but not through the body and deep slots or shafts extending axially, down from the top of the body, but terminating inside the body, i.e. above the bottom surface of the body. In these latter slots or shafts, which may all have rectangular cross sections and all having their sides parallel to each other, various strips of electrode material are inserted, two of these then for example having free surface areas inside the transverse channel or slot to form the measurement cell.

### BRIEF DESCRIPTION OF THE DRAWINGS

The invention will now be described in greater detail by way of a non-limiting exemplary embodiment with reference to the accompanying drawings, in which:
Fig. 1 is is perspective view of a pilot cell,
Fig. 2 is an elevational view of the pilot cell where a protective grid has been removed,
Fig. 3 is a cross-sectional view of the pilot cell of Fig. 2 taken along the line III-III,
Figs. 4 and 5 are sectional views as seen in longitudinal directions of the pilot cell of Figs. 2 and 3, the sections being taken along the lines IV-IV and V-V respectively in Fig. 3,
Fig. 6 is a circuit diagram of the pilot cell and an electrical control circuit therefor,
Figs. 7a and 7b are portions of a flow diagram of steps carried out by the control circuit in the control of the pilot cell,
Fig. 8 is a perspective view of a starter battery having a pilot cell mounted therein, part of the battery enclosure being cut-away,
Fig. 9 is a detail of Fig. 8 in a large scale.

### DETAILED DESCRIPTION

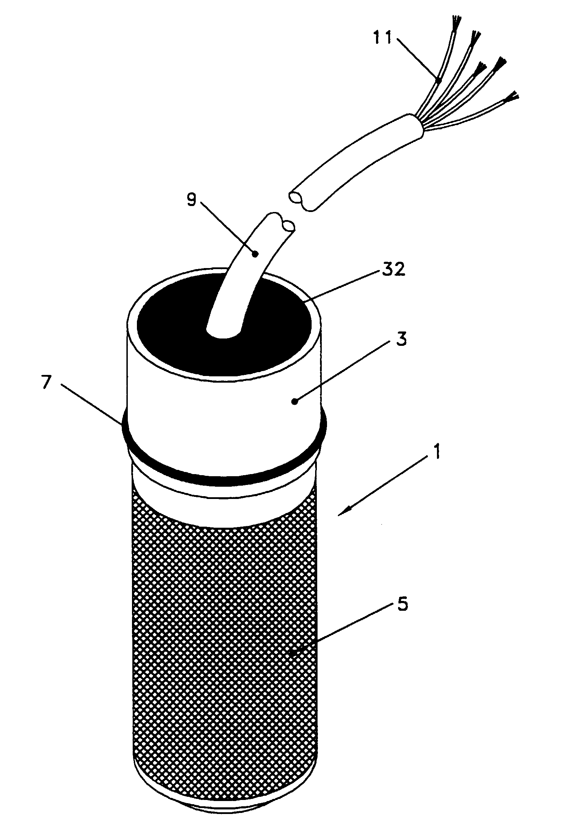

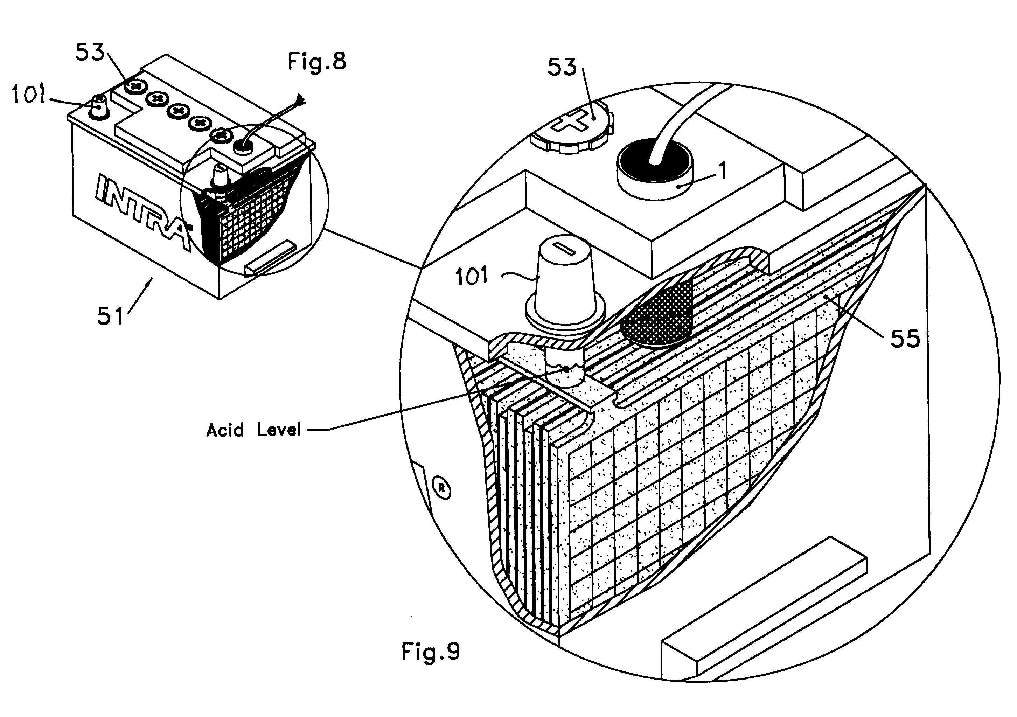

In Fig. 1 a pilot cell 1 is depicted that is intended to be inserted in an electrolytic cell, in particular an electrolytic cell in an electrochemical battery which preferably is the lead acid type. The pilot cell has a generally cylindrical shape comprising a body 3 of a suitable electrically isolating, acid-resistant plastics material. On the lower part of the body 3 a cylindrical grid 5 is attached allowing the electrolytic fluid in the battery cell to enter and make contact with the interior of the pilot cell 1. On the top portion of the pilot cell 1 which is constituted of a cylindrical part of the body 3 an annular sealing element 7 may be attached for sealing and possibly also maintaining the pilot cell 1 in its proper position by being introduced through a suitable through-hole of a lid of the battery cell, see Figs. 8 and 9. From the top surface of the pilot cell 1 an electrical cable 9 extends containing a plurality of electrical conductors 11 which are electrically isolated from each other and which are connected to a monitor circuit, as will be described hereinafter.

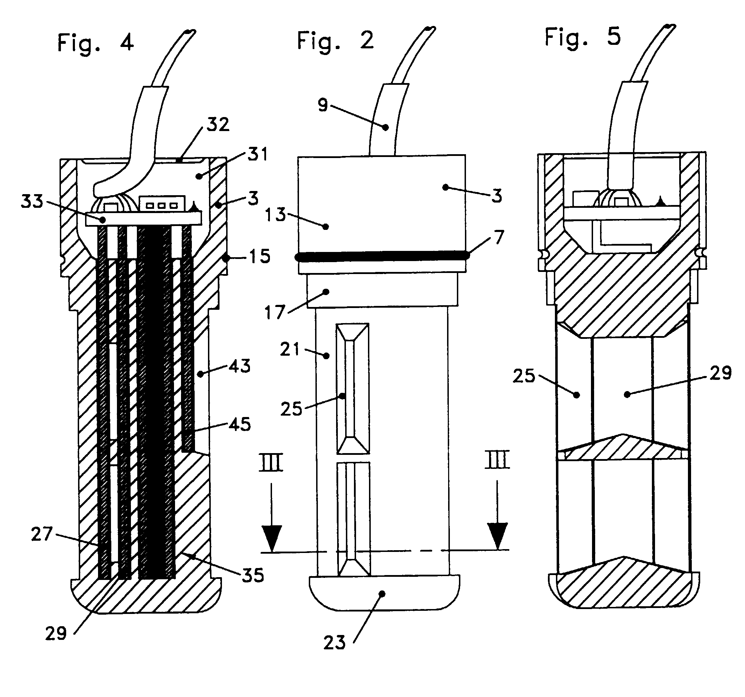

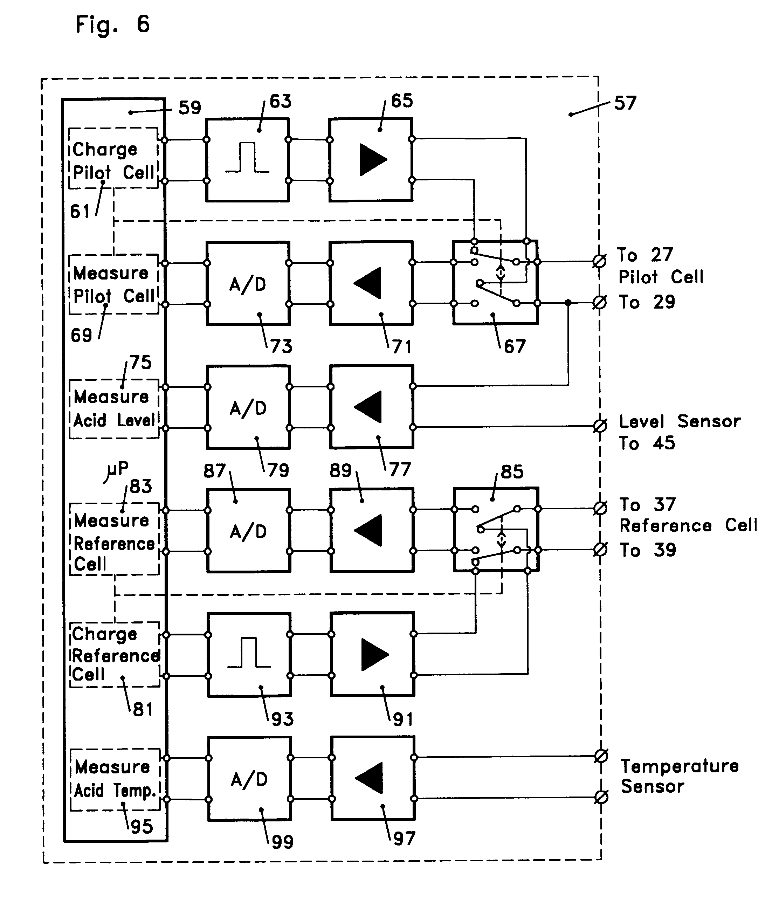

In Fig. 2 the pilot cell is illustrated as seen from the side thereof, the protective grid 5 being removed from the body 3. The body 3 has, as has already been mentioned, a top cylindrical portion 13. This portion comprises an annular groove 15 for the sealing ring 7, see the sectional views of Figs. 4 and 5, the groove 15 being located in the vicinity of the lower edge of the top cylindrical portion 13. This portion 13 ends at its lower edge in a step for forming a shoulder 17 intended to support the protective grid 5. The shoulder 17 also ends in a step at its lower edge where the body 3 continues as a rather long cylindrical central portion 21 comprising various openings for electrode surfaces to be described hereinafter. At the lower end of the central portion 21 there is another step forming a bottom portion 23, the upper cylindrical portion of which also serves as a support for the grid 5. An annular space is formed between the grid 5 and the surface of the thinner, cylindrical central portion of the body part 3.

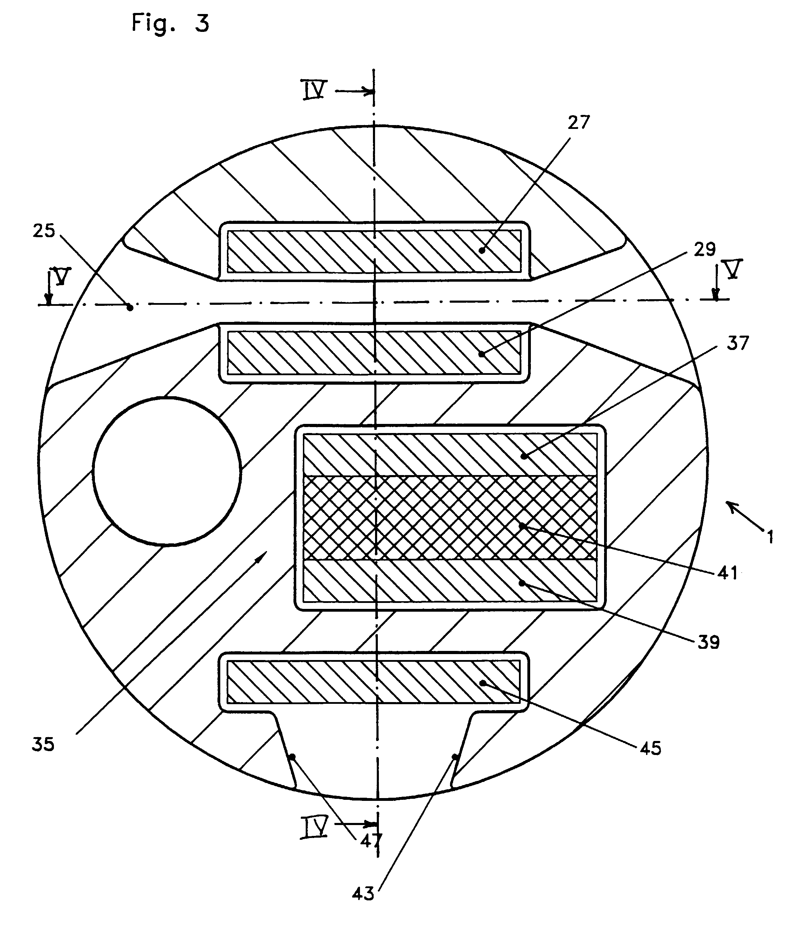

The central, thinnest portion 21 of the body 3 has elongated openings or windows 25, that extend in the longitudinal or axial direction of the pilot cell 1 and are located aligned with and on top of each other. These windows 25 have tapering or bevelled inlets and outlets, see in particular the cross sectional view of Fig. 3. The inner portion of the windows 25 has parallel sides which are located at a small distance of each other. These side surfaces are the active surfaces of electrode plates 29, the electrodes being the same type as one electrode of the battery cell, in which the pilot cell is intended to be inserted, and generally the electrode plates being made of lead material. These plates 27 and 29 have the shape of rather thin strips of material having a generally rectangular shape. The other large surfaces of the electrode plates 27 and 29 and also the longitudinal edges thereof are in contact with corresponding surfaces of the body 3, the electrode plates 27 and 29 thus being located in interior slots or shafts in the body 3, which are closed at their lower ends. The electrode plates 27 and 29 have their lowest region at the level of the step forming the lower grid support 23, the lower edge of the electrode plates thus also being in contact with the material of the body 3. The only surfaces of the electrode plates 27 and 29 which are exposed to the electrolyte of the battery cell, in which the pilot cell is intended to be inserted or submerged, are portions of their opposite inner large surfaces forming the inner part of the windows 25.

The windows or channels 25 extend generally along a plane, that is parallel to the axis or longitudinal direction of the pilot cell and the body part 3, this plane being located at some distance from this axis, e.g. at about a distance of half or one third of the radius of the grid 5 supported by the surfaces 17 and 23. As viewed in the cross sectional view of Fig. 3, the electrode plates 27 and 29 are located entirely inside the material of the body part 3 and only portions of their opposite, facing large surfaces are exposed to the electrolyte of the surrounding battery cell. The top part of the electrodes 27 and 29 extend into an upper recess 31 in the body 3, this recess 31 extending downwards from the top surface of the body 3 and having a generally cylindrical shape. A lid 32 is placed at the top of the recess 31 to close this space. The electrodes 27 and 29 here extend to an insulating plate 33 to which the cable 9 can be mechanically attached, the electrical conductors of the cable 9 being soldered to the electrode plates 27 and 29. The lid 32 has a suitable hole for allowing the cable 9 to pass therethrough.

Totally enclosed in the material of the body part 3 is a reference cell 35. It has electrode plates 37 and 39 similar to the electrode plates 27 and 29 respectively, an electrolyte of the same type as the battery cell in which the pilot cell 1 is intended to be submerged, the electrolyte having a known and definite composition and being located in the space formed by the two opposite, facing large sides of the electrodes 37 and 39. The electrode plates are thus parallel to each other and also to the other electrode plates 27 and 29. The electrodes 37 and 39 of the reference cell are located more centrally within the body part 3 than the other electrodes, e.g. so that the axis of the pilot cell and the body part 3 extends inside or along one of the electrode plates 37 and 39. Also, the distance of the electrodes 37 and 39 in the reference cell 35 is larger than the distance of the other electrodes 27 and 29 of each other. The electrodes 37 and 39 and the electrolyte 41 are located inside a blind hole or slot that is closed at its bottom end and has a generally rectangular shape and extends downwards from the bottom of the top recess 31. Also, the reference electrodes 37 and 39 extend up to the plate 33 to be there connected to electrical conductors of the cable 9.

In the central thinner portion 21 of the body 3 a recess 43 is made, this recess being elongated and located generally in parallel to the axis of the pilot cell 1. At the bottom of this recess 43 an electrode plate 45 is located, that is the type of one of the electrodes of the battery cell for which the pilot cell 1 is intended, for example in the case of lead acid battery this electrode can be a lead sheet or lead strip. This strip electrode 45 works as an electrode for checking the level of the electrolyte of the battery cell for which the pilot cell 1 is intended. It also extends up to the support plate 33 to be soldered to a conductor of the cable 9. It is located in a rectangular hole or groove passing inside the body part 3, the only area of this electrode plate 45 being that portion of one of the large surfaces thereof which is located inside the lateral recess 43. This recess 43 has sides 47 that has such a slope that the recess is tapering with a more narrow surface portion or mouth portion than the inner portion thereof. The lateral window 43 only extends along a longitudinal portion of the thinner central part of the body 3 so that the lowest point of the recess 43 is located at a level higher than the lowest portion of the exposed areas of the test electrodes 27 and 29 inside the lower one of the windows 25. This high level can be chosen appropriately for the level electrode 45 to work as intended as will be described hereinafter.

In the body 3 a cylindrical bore 49 is provided extending in parallel to the axis of the pilot cell 1. The bore 49 can be a blind hole or a through hole and is intended for accommodating a suitable temperature sensor, not shown, also intended to be connected to some of the electrical conductors of the cable 9.

The level electrode 45 is also located generally in parallel to the test electrodes 27 and 29 and the reference electrodes 37 and 39 and also the large surfaces of the test electrodes 27 and 29 and the level electrode 45 can all have the same longitudinal perpendicular symmetry plane, this plane being a diameter plane of the pilot cell 1. The reference cell 41 is then located between the test electrodes 29 and the level electrode 45 but a little displaced from said symmetry plane.

In Fig. 8 a perspective view of a conventional starter battery 51 of lead acid type is shown having six cells. Each cell is provided with an inspection and refill opening closed by a threaded plug 53, one plug 53 of the cells being replaced by a pilot cell 1. As is illustrated in the fragmentary view of Fig. 9, the pilot cell 1 is located closely above the cell plates 55 of the cell.

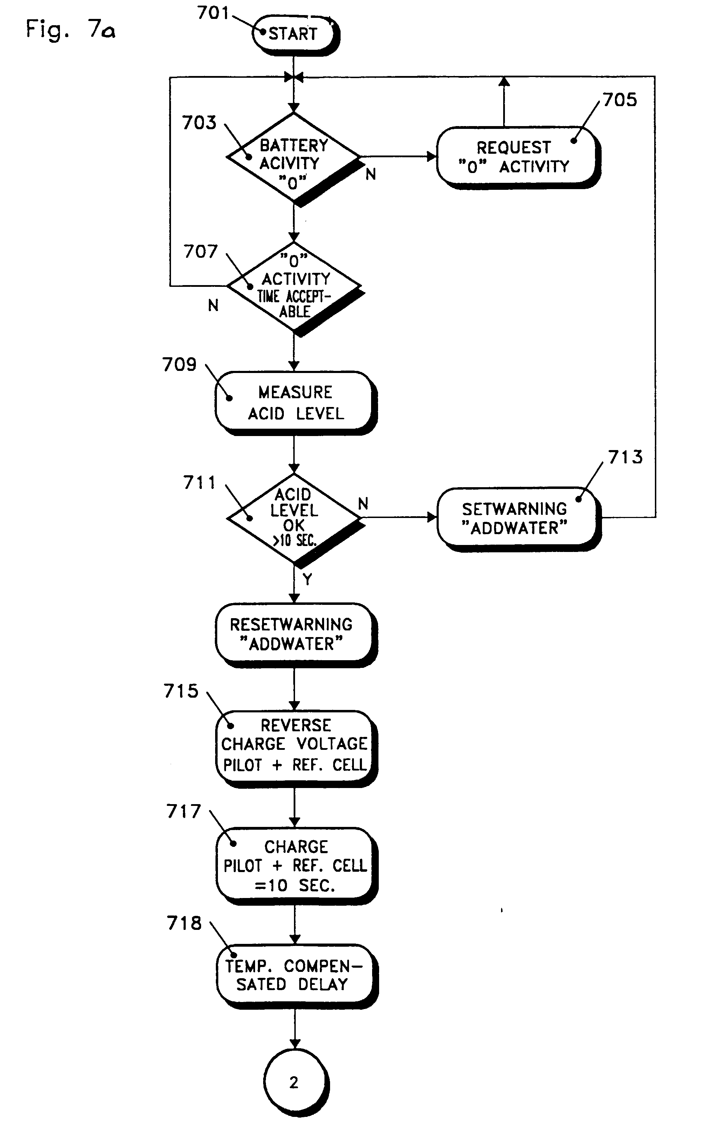

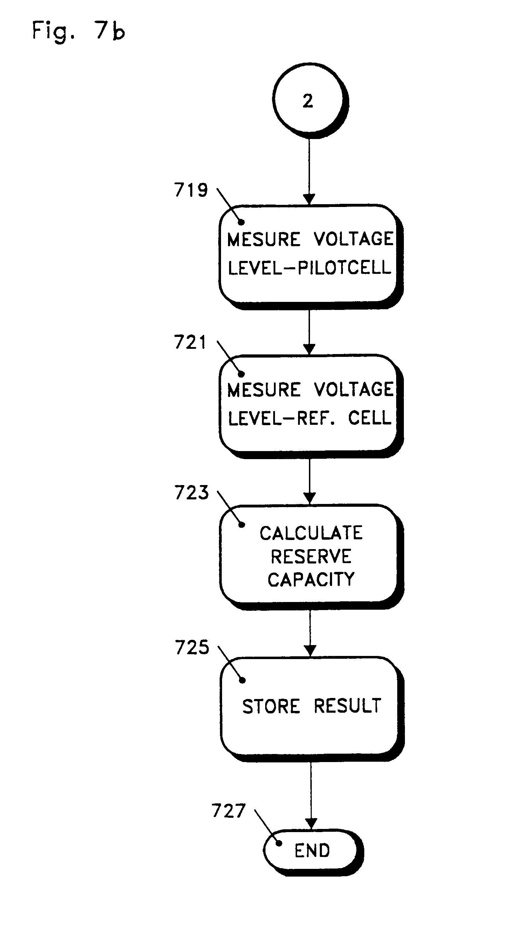

In Fig. 6 a block diagram is shown illustrating the operation of the pilot cell and the parts thereof as connected to a monitor circuit 57 that comprises a central control circuit 59, for example a conventional one-chip microcomputer. The various electrodes of the components of the pilot cell are connected to the control circuit 59 through suitable switches and/or signal conditioning devices. The control device 59 basically executes a control sequence according to the flow diagram as illustrated in Figs. 7a and 7b, at periodically repeated times, as will be described hereinafter.

The central control circuit 59 comprises several modules handling the devices of the pilot cell. Thus a first module 61 controls the charging of the very pilot cell or measurement cell, that is the cell constituted of the electrodes 27, 29 and the electrolyte of the monitored battery cell. This module controls a pulse generating circuit 63 generating a pulse of a predetermined length, this pulse being amplified in an amplifier 65. The amplified pulse having a length a several seconds is supplied to the electrodes 27, 29 through a power switch 67 that is controlled by the module 61 to the appropriate position.

A second module 63 in the central control 59 handles the measurements made on the measurement cell having electrodes 27, 29. This module also controls the power switch 67 to make it take the position for a measurement and then the electrodes 27, 29 are connected through the power switch to apply the voltage therebetween to the input terminals of an amplifier 71. The amplified signal is converted to a digital shape in an A/D converter 73 and is then processed in the module 69.

A module 75 handles the measurement of the electrolyte level and is thus connected to the level measurement electrode 45 and one of the electrodes of the very pilot cell, for example to the electrode 29. The connection is made through an amplifier 77 and an A/D converter 79 supplying a digital signal to the module 75 for evaluation and possibly triggering some alarm.

Modules 81 and 83 analogous to the modules 61 and 69 respectively handle the charging of and the measurement on the reference cell 35 and they therefor control a power switch 85 similar to the switch 67. The power switch 85 is thus connected to the electrodes 37 and 39 of the reference cell. The module 81 for charging the reference cell is connected to the power switch 85 through a pulse generating circuit 87 and a power amplifier 89. The module 83 for making the measurement on the reference cell 35 is connected to the power switch 85, so that voltage on the reference electrodes 85 is amplified in an amplifier 91 and converted to digital pulses in an A/D-converter 93. Finally there is a module 95 for measuring the temperature of the electrolyte. Thus it is intended to be connected to the temperature sensor to be lodged in the bore 49 and it receives the signal from the sensor through an amplifier 97 and an A/D-converter 99.

The procedural steps executed by control device 59 are shown in the flow diagram of Figs. 7a and 7b. The procedure starts in a start block 701 and then, in order to able to make a reliable measurement, it is determined whether the battery is and has been in "rest mode", that is in a state where no electrical current flows through the battery, for a sufficiently long time period. Thus, it is first decided in a block 703 whether there at the current instant is some activity in the battery, i.e. whether it is discharged or charged. This can be made by sensing that there is no current flowing through some suitable resistor connected in series with the battery cells, as e.g. is described in the cited International patent applications Nos. PCT/SE95/00767 and PCT/IB95/00835 which are incorporated herein by reference. If the battery is not inactive a request is made in a block 705 for a period of inactivity, i.e. that no current is to flow through the battery. This can only be made in the case where for example the battery 103 is installed together with a control network controlling the discharge and charge thereof such as in automotive intelligent battery monitoring systems, as disclosed in the cited International patent application PCT/IB95/00835. After the request in the block 705 the block 703 is performed again.

If it is decided in the block 703 that the battery is not active it is asked in a block 707 whether the battery has been in a rest or inactive state for a sufficient time period. The length of this time period is set depending on the temperature and the age of the battery. Typically time periods may be 2 - 3 hours for a temperature of -20°C and 5 - 15 minutes at +20°C. If the time period is not long enough, the block 703 is executed again. In the opposite case, where such a time period of inactivity has been achieved, first the level of the battery electrolyte or acid will be checked. The condition that the acid level is satisfactory is important for two reasons. First an acid level which does not cover the cell arrangement in the battery will derate the nominal capacity of the battery and will in the worst case damage the battery. Secondly, in the case where the acid level is below the lower edge of the electrode plates 27, 29 of the very pilot cell, the capacity calculation to be made later will be unreliable and the try to charge of the pilot call can in the worst case damage the pilot cell.

Thus the acid level is measured in a block 709, the measurement being performed by measuring the electrical voltage of the battery cell constituted by the level sensor electrode plate 45 and one of the electrode plates 27, 29 of the pilot cell and comparing the measured electrical quantity to a suitable threshold value. This measurement must be made for a suitable time period, for instance a time period longer than 10 seconds, for providing a reliable measurement. Vibration, inclination and centrifugal forces can, also for a satisfactory average acid level, always cause that the acid level will be low at localized places within the battery during short time periods, this necessitating that the measurement is made during a time period having a satisfactory length. It is then decided in a block 711 whether the acid level has been correct during this time period. If it is decided in the block 711 that the acid level was not appropriate, a warning is set in a block 713, for instance by illuminating some indicator in a control panel of the monitoring system, not shown, for the battery 103. Then the block 703 is executed again.

If it was decided in the block 711 that the acid level was correct during the time period selected then the actual test cell voltages will be determined. First, it is examined in a block 715 whether there is time for reversing the direction of the charge current through the pilot and reference cells, and if it is required the reversion is made. A reversing operation is required since generally charging and/or discharging a battery cell of cause result in some mechanical wear and/or mechanical or chemical decomposition of particularly the positive part of the cell. This will be even more important for the cell plates of especially the pilot or measurement cell owing to the small volume and area of the cell plates thereof. The polarity can for instance be changed for each charging instance resulting in a prolonged life time of the cell. Also, it may be possible to have fewer changes of the charging direction. Thus, as preferred here the charge voltage for the very pilot cell consisting of the electrodes 27 and 29 and the storage battery electrolyte therebetween and the reference cell 35 is reversed in block 715. Then in a block 717 the very pilot cell and the reference cell are charged during a suitable time period of for example 10 seconds, the length of this time period being set depending on the temperature of the battery. Then the procedure stops for a suitable time period in a block 718, the delay being calculated based on the temperature of the battery.

After that, in a block 719 the open circuit voltage of the very pilot cell is measured and in a block 721 the same voltage is measured for the reference cell 35. Based on these measurements and earlier measurements of the same quantities which are supposed to be stored in a memory of the control device 59, the charge state of the battery is calculated and in particular the reserve capacity of the battery. Such a calculation can be based on the methods as described in U.S. patent US-A 5,151,865. Finally the calculated result is stored in a block 725 and the procedure is ended in a block 727.

Using these stored results and also the actual cell voltage which can be measured directly by the control device 59 as the voltage between the positive and negative terminals 101 of the battery divided by six the acid density of the electrolyte can also be calculated.

## Claims

1. A measurement device for insertion in an electrolyte of a storage battery, which storage battery has electrodes in contact with its electrolyte, the measurement device comprising a first pair of electrodes having active surfaces in contact with the electrolyte of the storage battery, the electrodes of the first pair being the same kind as the storage battery electrodes, the electrodes of the first pair and the storage battery electrolyte forming a measurement electrolytic cell, the voltage of which is measured, **characterized by** a reference electrolytic cell, comprising a second pair of electrodes of also the same kind as the electrodes of the storage battery and in contact with an electrolyte of the same kind as the storage battery electrolyte but separate therefrom, the voltage of the reference electrolytic cell being measured and used for correcting the measured voltage of the measurement electrolytic cell and/or for forming a reference voltage, to which the voltage of the measurement electrolytic cell is compared, in order to provide voltage values upon which a determination of the charge state of the storage battery is made.

2. A measurement device according to claim 1, **characterized by** a control circuit connected to the electrodes of the first and second pairs and arranged to charge the measurement voltage cell and the reference voltage cell before a measurement of the voltages of these cells are made.

3. A measurement device according to claim 2, **characterized in** that the control circuit is arranged to introduce a delay of a predetermined length, after charging the measurement voltage cell and the reference voltage cell and before a measurement of the voltages of these cells are made.

4. A measurement device according to one of claims 2 - 3, **characterized in** that the control circuit is arranged to reverse the polarity of a voltage charging the measurement voltage cell and the reference voltage cell between each measurement of the voltages of these cells.

5. A measurement device according to one of claims 2 - 4, **characterized in** that the control circuit is arranged to check, before a measurement of the voltages of the measurement voltage cell and the reference voltage cell, whether the storage battery has been in a rest or inactive state for a predetermined time period, and to postpone the measurement until such a predetermined time period has been achieved.

6. A measurement device according to one of claims 1 - 5, **characterized by** a level electrode of the same kind as one of the electrodes of the storage battery, the level electrode having an active surface intended to be in contact with the storage battery electrolyte when the measurement device is inserted therein, the active surface of the level electrode then having a lower edge located at a predetermined level, whereby, by checking whether the electrolytic cell formed by the level electrode and another electrode of the measurement device or of the storage battery has any output voltage or by checking the electrical resistance between said electrodes, it can be indicated whether the level of the battery electrolyte is higher or lower than the predetermined level.

7. A measurement device according to one of claims 1 - 6, **characterized in** that the electrodes of the first pair are formed as plates having active surfaces which plates are located having only their active surfaces in contact with the storage battery electrolyte, the active faces being so configured and located that they face each other at a small distance from each other, a narrow first slot or channel being formed between the active surfaces.

8. A measurement device according to claim 7, **characterized by** a body of an electrically isolating material, the body having a generally cylindrical shape, a second slot or channel passing through the body and the electrode plates of the first pair being located to have their active surfaces constituting portions of walls of the slot or channel, so that the first slot or channel constitutes a part of the second slot or channel.

9. A measurement device for insertion in an electrolyte of a storage battery, which storage battery has electrodes in contact with the electrolyte, the measurement device comprising a pair of electrodes having active surfaces in contact with the electrolyte of the storage battery, the electrodes of the pair being the same kind as the storage battery electrodes and the electrodes of the pair and the storage battery electrolyte forming a measurement electrolytic cell, the voltage of which is measured, **characterized in** that the electrodes of the pair are formed as plates having active surfaces which plates are located having only their active surfaces in contact with the storage battery electrolyte, the active faces being so configured and located that they face each other at a small distance from each other, a narrow first slot or channel being formed between the active surfaces.

10. A measurement device according to claim 9, **characterized by** a body of an electrically isolating material, the body having a generally cylindrical shape, a second slot or channel passing through the body and the electrode plates of the pair being located to have their active surfaces constituting portions of walls of the slot or channel, so that the first slot or channel constitutes a part of the second slot or channel and other surfaces of the electrode plates of the pair being located in contact with inner wall portions of the body.
